# EUROPEAN PATENT APPLICATION

(11) **EP 4 462 967 A1**
(43) Date of publication of application: **13.11.2024**
(21) Application number: 22920710.5
(22) Date of filing: 14.01.2022
(51) Int. Cl.: H05K 5/03, H05K 5/00

(54) **DISPLAY DEVICE**

(71) Applicant: LG Electronics Inc., Yeongdeungpo-gu Seoul 07336 (KR)
(72) Inventor: PYO, Jonggil, Seoul 06772 (KR); DO, Honghae, Seoul 06772 (KR)
(74) Representative: Schornack, Oliver
(86) International application number: PCT/KR2022/000749
(87) International publication number: WO 2023/136377

(57) **Abstract**

Disclosed is a display device. The display device of the present disclosure may include a base; a drive module coupled to the base, the drive module including a slider which performs a linear reciprocating motion; a plate coupled to the slider; a display panel coupled to the plate in front of the plate; a first guide shaft which extends in a direction of movement of the slider, and to which one end of the plate is movably coupled; and a second guide shaft which is opposite to the first guide shaft with respect to the slider, which is parallel to the first guide shaft, and to which the other end of the plate is movably coupled.

## Description

### [TECHNICAL FIELD]

The present disclosure relates to a display device.

### [BACKGROUND ART]

As information society develops, the demand for display devices is also increasing in various forms. In response to this, various display devices such as Liquid Crystal Display Device (LCD), Plasma Display Panel (PDP), Electroluminescent Display (ELD), Vacuum Fluorescent Display (VFD), and Organic Light Emitting Diode (OLED) have been researched and used in recent years.

Among these, a liquid crystal panel includes a TFT substrate and a color filter substrate that face each other with a liquid crystal layer interposed therebetween, and may display an image by using light provided from a backlight unit. In addition, an OLED panel may display an image by depositing an organic material layer capable of self-emitting light on a substrate on which a transparent electrode is formed.

Recently, a lot of research has been done on a structure that covers the front surface of a display panel.

### [DETAILED DESCRIPTION OF INVENTION]

### [TECHNICAL PROBLEMS]

It is an object of the present disclosure to solve the above-described problems and other problems.

Another object may be to provide a display device that can open or close the front surface of a display panel.

Another object may be to provide a structure that allows a display panel to be moved.

Another object may be to provide a structure that can minimize a left-right tilting due to the up-down movement of a display panel.

Another object may be to provide a structure that can alleviate the impact caused by the up-down movement of a display panel.

### [TECHNICAL SOLUTION]

In accordance with an aspect of the present disclosure to achieve the above and other objectives, a display device may include: a base; a drive module coupled to the base, the drive module including a slider which performs a linear reciprocating motion; a plate coupled to the slider; a display panel coupled to the plate in front of the plate; a first guide shaft which extends in a direction of movement of the slider, and to which one end of the plate is movably coupled; and a second guide shaft which is opposite to the first guide shaft with respect to the slider, which is parallel to the first guide shaft, and to which the other end of the plate is movably coupled.

### [EFFECT OF INVENTION]

The effects of the display device according to the present disclosure will be described as follows.

According to at least one of the embodiments of the present disclosure, it is possible to provide a display device that can open or close the front surface of a display panel.

According to at least one of the embodiments of the present disclosure, it is possible to provide a structure that allows a display panel to be moved.

According to at least one of the embodiments of the present disclosure, it is possible to provide a structure that can minimize a left-right tilting due to the up-down movement of a display panel.

According to at least one of the embodiments of the present disclosure, it is possible to provide a structure that can alleviate the impact caused by the up-down movement of a display panel.

Further scope of applicability of the present disclosure will become apparent from the following detailed description. However, it should be understood that the detailed description and specific embodiments such as preferred embodiments of the present disclosure are given by way of illustration only, since various changes and modifications within the spirit and scope of the present disclosure may be clearly understood by those skilled in the art.

### [BRIEF DESCRIPTION OF THE DRAWING]

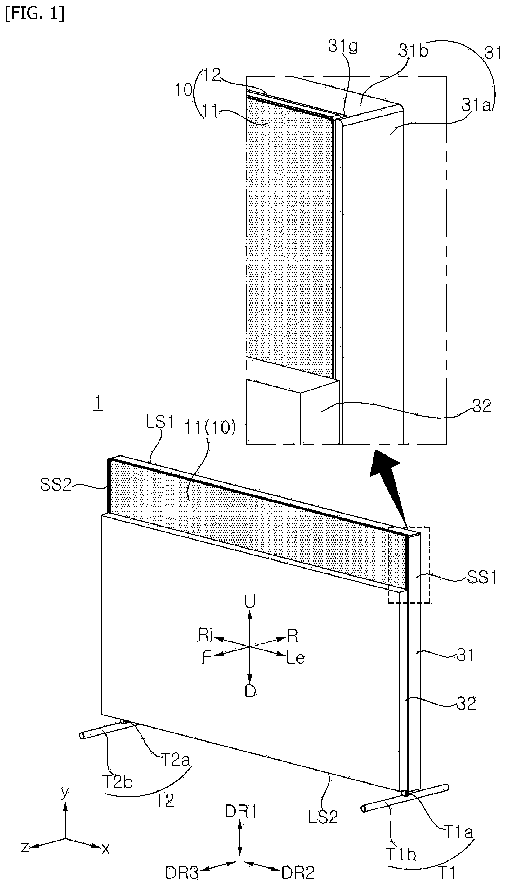

FIGS. 1 to 20 are diagrams illustrating examples of a display device according to embodiments of the present disclosure.

### [MODE FOR CARRYING OUT THE INVENTION]

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In general, suffixes such as "module" and "unit" may be used to refer to elements or components. Use of such suffixes herein is merely intended to facilitate description of the specification, and the suffixes do not have any special meaning or function.

In the present disclosure, that which is well known to one of ordinary skill in the relevant art has generally been omitted for the sake of brevity. The accompanying drawings are used to assist in easy understanding of various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are only used to distinguish one element from another.

It will be understood that when an element is referred to as being "connected with" another element, there may be intervening elements present. In contrast, it will be understood that when an element is referred to as being "directly connected with" another element, there are no intervening elements present.

A singular representation may include a plural representation unless context clearly indicates otherwise.

In the present application, it should be understood that the terms "comprises, includes," "has," etc. specify the presence of features, numbers, steps, operations, elements, components, or combinations thereof described in the specification, but do not preclude the presence or addition of one or more other features, numbers, steps, operations, elements, components, or combinations thereof.

Direction indications of up (U), down (D), left (Le), right (Ri), front (F), and rear (R) shown in the drawings are only for convenience of explanation, and the technical concept disclosed in this specification is not limited thereto.

Referring to FIG. 1, a display device 1 may include a display panel 11. The display panel 11 may display an image.

The display device 1 may include a first long side LS1, a second long side LS2 opposite to the first long side LS1, a first short side SS1 adjacent to the first and second long sides LS1 and LS2, and a second short side SS2 opposite to the first short side SS1. Meanwhile, for convenience of description, it is illustrated that the length of the first and second long sides LS1 and LS2 are longer than the length of the first and second short sides SS1 and SS2, but it may also be possible that the length of the first and second long sides LS1 and LS2 are substantially equal to the length of the first and second short sides SS1 and SS2.

The direction parallel to the short side SS1, SS2 of the display device 1 may be referred to as a first direction DR1 or an up-down direction. The direction parallel to the long side LS1, LS2 of the display device 1 may be referred to as a second direction DR2 or a left-right direction. The direction perpendicular to the long side LS1, LS2 and short side SS1, SS2 of the display device 1 may be referred to as a third direction DR3 or a front-rear direction.

The direction in which the display panel 11 displays images may be referred to as a forward direction (F, z), and the opposite direction may be referred to as a rearward direction R. The side of the first short side SS1 may be referred to as a left side (Le, x). The side of the second short side SS2 may be referred to as a right side Ri. The side of the first long side LS1 may be referred to as an upper side (U, y). The side of the second long side LS2 may be referred to as a lower side D.

The first long side LS1, the second long side LS2, the first short side SS1, and the second short side SS2 may be referred to as an edge of the display device 1. In addition, points where the first long side LS1, the second long side LS2, the first short side SS1, and the second short side SS2 meet each other may be referred to as a corner.

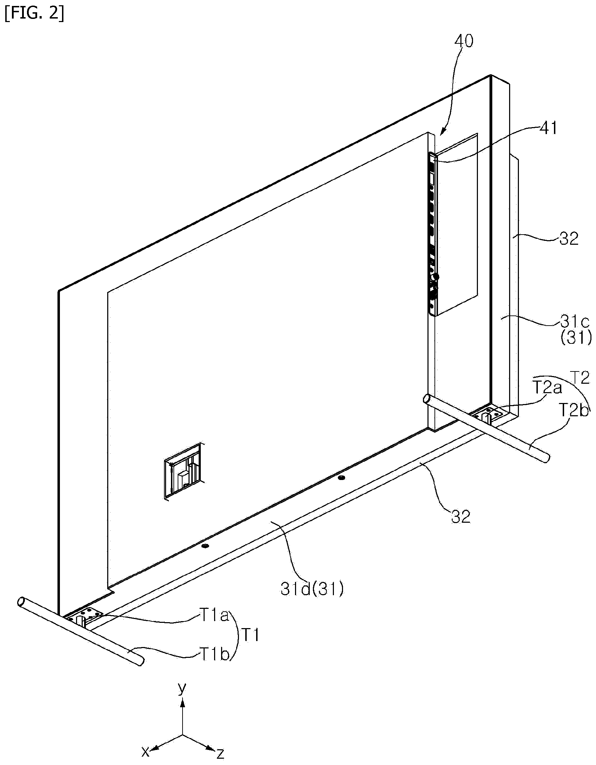

Referring to FIGS. 1 and 2, a front case 32 may be located in front of the display panel 11 and may cover at least a portion of the front surface of the display panel 11. A front case 32 may form at least a portion of the front surface of the display device 1.

A side case 31 may extend along the circumference of the display panel 11 and cover the lateral surface of the display panel 11. A first part 31a may form the left side of the side case 31, and a second part 31b may form the upper side of the side case 31. A third part 31c may form the right side of the side case 31, and a fourth part 31d may form the lower side of the side case 31.

A rear case 40 may be opposite to the front case 32 with respect to the side case 31. The rear case 40 may form the rear surface of the display device 1. The front case 32, side case 31, and rear case 40 may be coupled with each other.

Input/output units 41 may be formed on one side of the rear case 40. For example, the input/output units 41 may include a video and/or audio input/output terminal, a USB terminal, or a power input terminal.

A stand T1, T2 may support the display device 1. The stand T1, T2 may include a first stand T1 and a second stand T2 that are spaced apart from each other in the left-right direction. The stand T1, T2 may include a fixing portion T1a, T2a coupled to the fourth part 31d of the side case 31, and a support portion T1b, T2b which is connected to the fixing portion T1a, T2a and placed on a ground, etc.

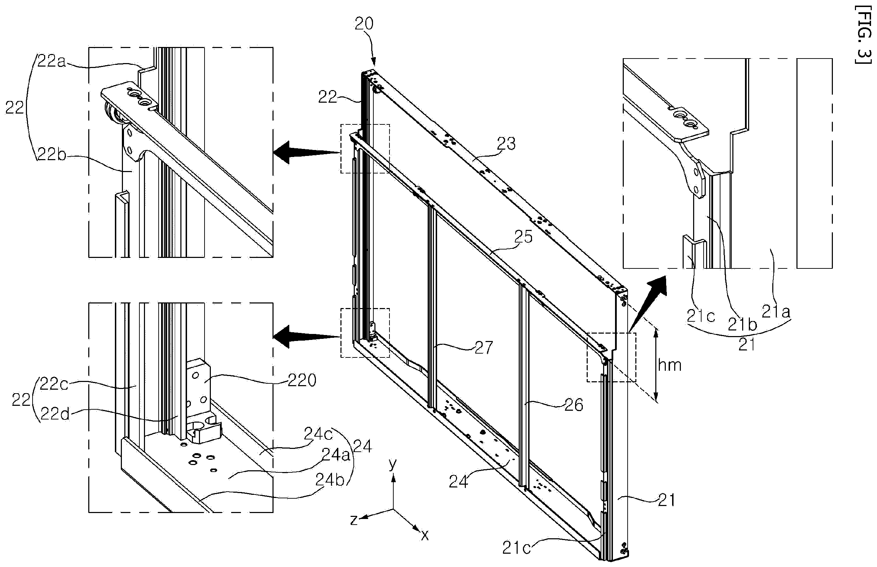

Referring to FIG. 3, a frame 20 may form a skeleton of the display device. The frame 20 may be disposed in the inner space of the front case 32, side case 31, and rear case 40 described above. The frame 20 may include an outer frame 21, 22, 23, 24, a horizontal frame 25, and a vertical frame 26 and 27.

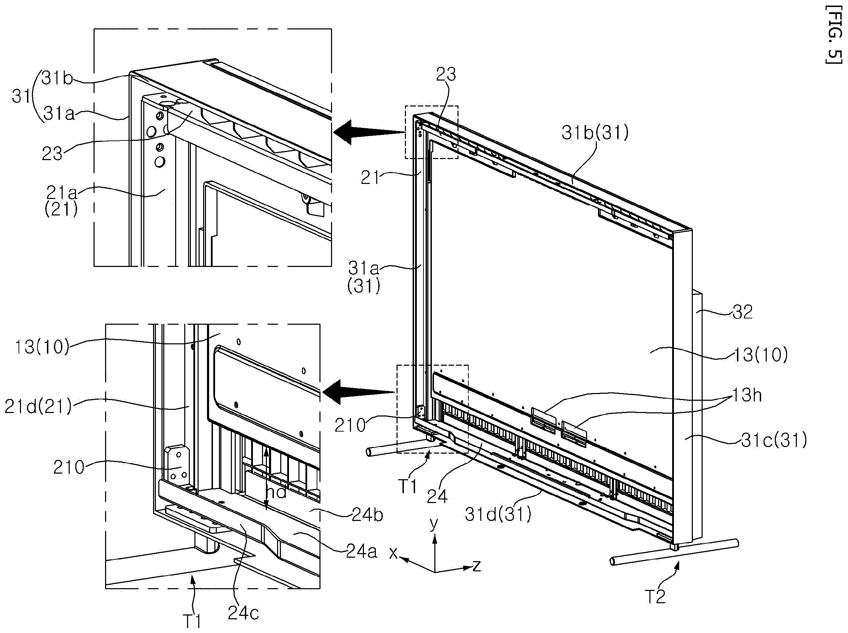

The outer frame 21, 22, 23, 24 may form the outer circumference of the frame 20. A first outer frame 21 may extend in the vertical direction and form the left side of the outer frame 21, 22, 23, 24. A second outer frame 22 may be opposite to the first outer frame 21 and form the right side of the outer frame 21, 22, 23, 24. A third outer frame 23 may extend in the horizontal direction and form the upper side of the outer frame 21, 22, 23, 24. The third outer frame 23 may be coupled to the upper end of the first outer frame 21 and the upper end of the second outer frame 22 through a fastening member. A fourth outer frame 24 may be opposite to the third outer frame 23 and may form the lower side of the outer frame 21, 22, 23, 24. The fourth outer frame 24 may be coupled to the lower end of the first outer frame 21 and the lower end of the second outer frame 22 through a fastening member 210, 220 (see FIGS. 3 and 5).

A first rib 21b may be bent to the right from the front end of a left portion 21a of the first outer frame 21. In addition, a first vertical rib 21c may be formed on the first rib 21b and/or the left portion 21a.

A second rib 22b may be bent to the right from the front end of a right portion 22a of the second outer frame 22. In addition, a second vertical rib 22c, 22d may be formed on the second rib 22b and/or the right portion 22a.

The horizontal frame 25 may be located between the first outer frame 21 and the second outer frame 22 and may extend in the horizontal direction. One end of the horizontal frame 25 may be coupled to the first rib 21b of the first outer frame 21, and the other end of the horizontal frame 25 may be coupled to the second rib 22b of the second outer frame 22. The horizontal frame 25 may be spaced downward from the third outer frame 23 (see hm). The horizontal frame 25 may be located closer to the third outer frame 23 than the fourth outer frame 24.

A vertical frame 26, 27 may be located between the horizontal frame 25 and the fourth outer frame 24 and may extend in the vertical direction. One end of the vertical frame 26, 27 may be coupled to the horizontal frame 25, and the other end of the vertical frame 26, 27 may be coupled to the fourth outer frame 24. The vertical frame 26, 27 may include a first vertical frame 26 and a second vertical frame 27 that are spaced apart from each other in the horizontal direction.

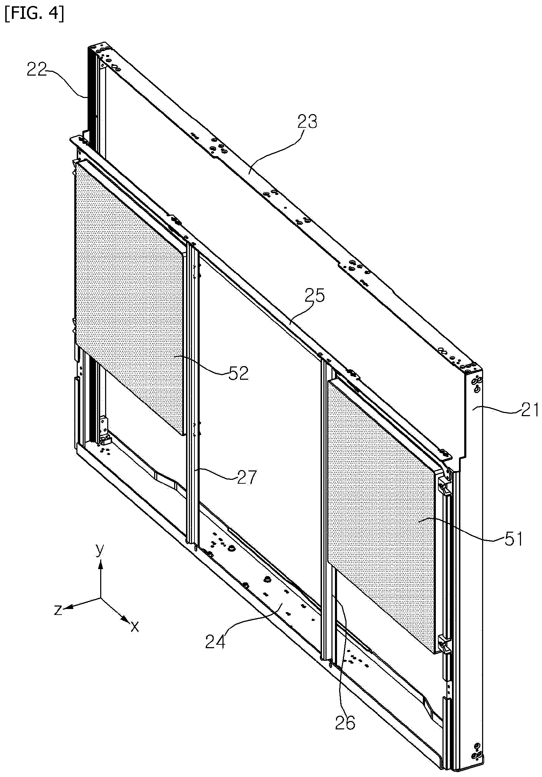

Referring to FIG. 4, a speaker 51, 52 may be located between the horizontal frame 25 and the fourth outer frame 24. A first speaker 51 may be coupled to the first rib 21b (see FIG. 3) of the first outer frame 21 and the first vertical frame 26. A second speaker 52 may be coupled to the second rib 22b (see FIG. 3) of the second outer frame 22 and the second vertical frame 27. The speaker 51, 52 may provide sound to the front of the display device.

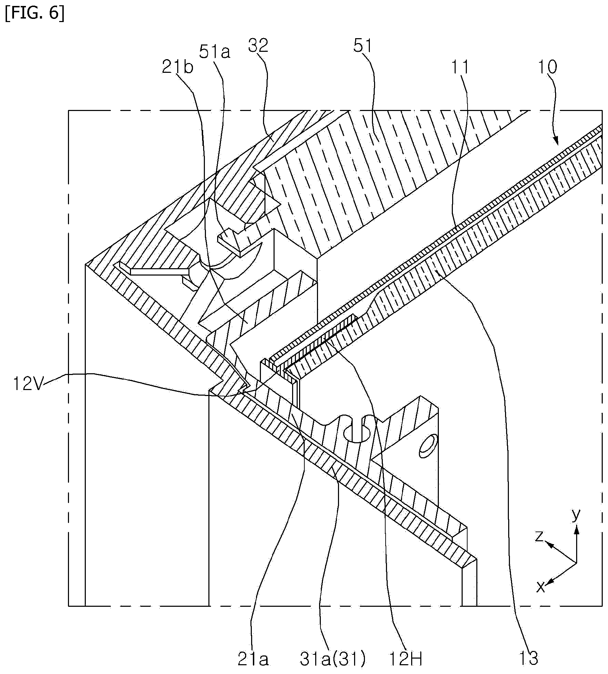

Referring to FIGS. 5 and 6, the speaker 51, 52 may be located inside the rear case 32. For example, a plurality of holes may be formed to penetrate the front surface of the rear case 32. Meanwhile, for example, the side case 31 and the rear case 32 may be formed as one body.

The first part 31a may cover the left surface of the first outer frame 21. The second part 31b may cover the upper surface of the third outer frame 23. The third part 31c may cover the right surface of the second outer frame 22 (see FIG. 4). The fourth part 31d may cover the lower surface of the fourth outer frame 24.

The display unit 10 may be located inside the outer frame 21 and located in a rear of the speaker 51, 52. In addition, the display unit 10 may be located in a rear of the horizontal frame 25 and the vertical frame 26, 27 (see FIG. 4). The display unit 10 may include a display panel 11, a middle cabinet 12, and a module cover 13.

For example, the display panel 11 may be an OLED panel, LCD panel, or LED panel. The display panel 11 can output an image by dividing an image into a plurality of pixels and adjusting the color, brightness, and saturation for each pixel. The display panel 11 may be divided into an active area where images are displayed and a de-active area where images are not displayed. The display panel 11 can generate light corresponding to the color of red, green, or blue according to a control signal.

The middle cabinet 12 (see FIG. 1) may form the lateral surface of the display unit 10. The horizontal portion 12H of the middle cabinet 12 may be located in a rear of the display panel 11 and may be coupled to the display panel 11. The vertical portion 12V of the middle cabinet 12 may intersect the horizontal portion 12H and cover the lateral surface of the display panel 11. For example, the middle cabinet 12 may include a metal or plastic material. The middle cabinet 12 may be referred to as a side frame or guide panel.

The module cover 13 may form the rear surface of the display unit 10. The module cover 13 may be opposite to the display panel 11 with respect to the horizontal portion 12H. The module cover 13 may be coupled to the horizontal portion 12H. For example, the module cover 13 may include a metal material. The module cover 13 may be referred to as a plate or frame.

A first hole 13h may be adjacent to the lower side of the module cover 13 and may be formed to penetrate the module cover 13. The first hole 13h may be referred to as a first cave hall.

Meanwhile, the fourth outer frame 24 may include a base 24a, a front rib 24b, and a rear rib 24c. The base 24a may face the fourth part 31d and may be spaced downward from the lower side of the module cover 13 (see hd in FIG. 5). The front rib 24b may be bent upward from the front end of the base 24a and may extend in the left-right direction. The rear rib 24c may be bent upward from the rear end of the base 24a and may extend in the left-right direction.

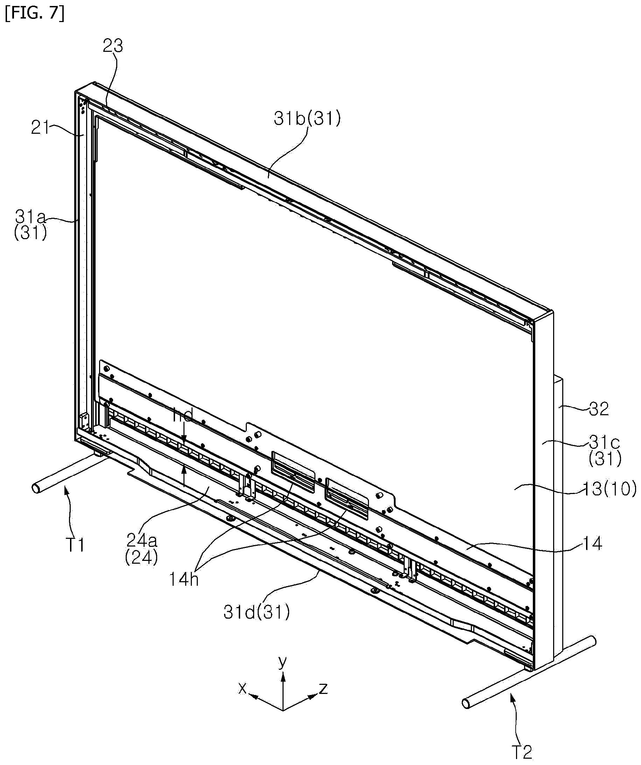

Referring to FIG. 7, a plate 14 may be adjacent to the lower side of the module cover 13 and may extend along the lower side of the module cover 13. One end of the plate 14 may be adjacent to the left side of the module cover 13, and the other end of the plate 14 may be adjacent to the right side of the module cover 13. The plate 14 may be coupled or fixed to the rear surface of the module cover 13. The lower side of the plate 14 may be spaced upward from the base 24a (see hd). For example, the plate 14 may include a metal material.

A second hole 14h may be formed to penetrate the plate 14. The second hole 14h may be aligned with the first hole 13h (see FIG. 5).

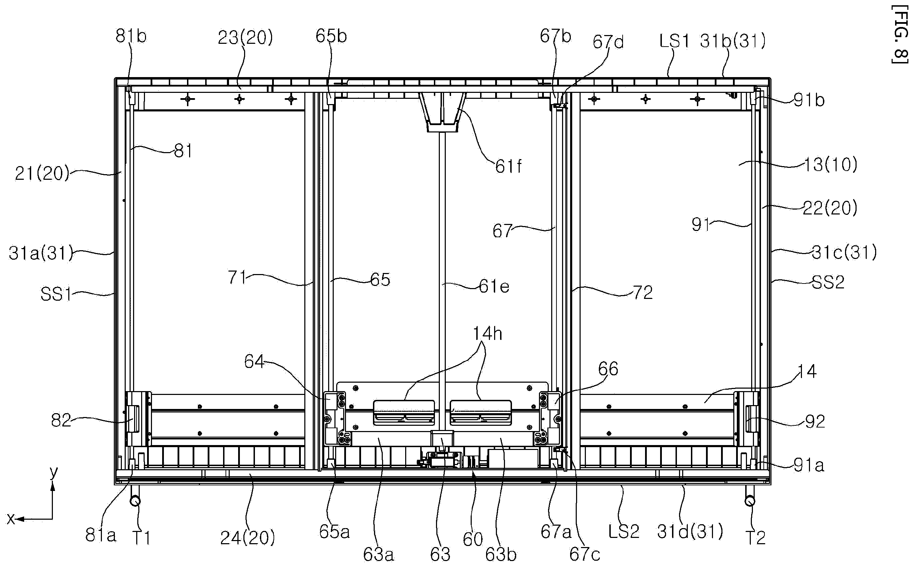

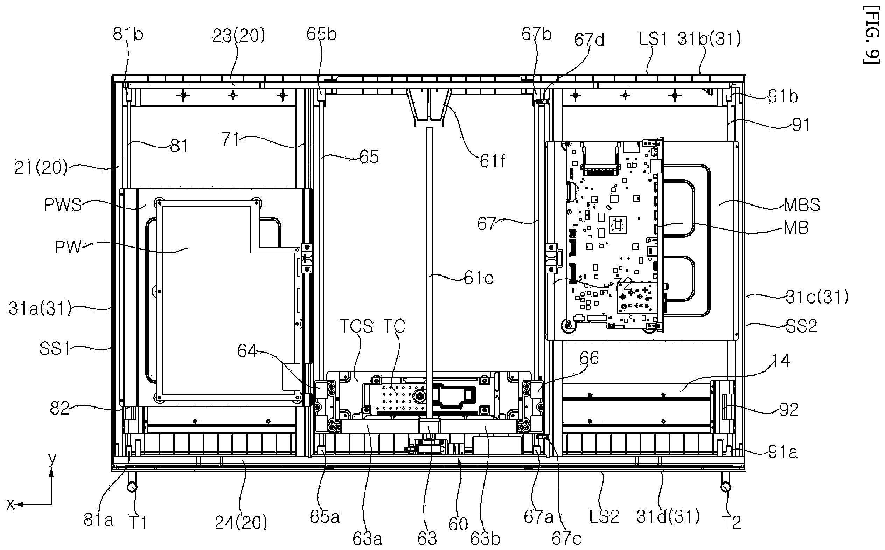

Referring to FIGS. 8 and 9, a bar 71, 72 may be located between the third outer frame 23 and the fourth outer frame 24 and may extend long in the vertical direction. The upper end of the bar 71, 72 may be fixed to the third outer frame 23, and the lower end of the bar 71, 72 may be fixed to the fourth outer frame 24. A first bar 71 may be located closer to the first outer frame 21 than the second outer frame 22. A second bar 72 may be located closer to the second outer frame 22 than the first outer frame 21.

A power supply board PW may be located in the rear of the module cover 13 and may be coupled to the first bar 71 through a first shield plate PWS. The power supply board PW can provide power to each component of the display device.

A main board MB may be located in the rear of the module cover 13 and may be coupled to the second bar 72 through a second shield plate MBS. The main board MB can control the display device.

A T-CON (Timing Controller) board TC may be located in the rear of the plate 14 and may be coupled to the plate 14 through a third shield plate TCS. At this time, the third hole may be formed to penetrate the third shield plate TCS and may be aligned with the second hole 14h. A cable (not shown) may penetrate the first hole 13h (see FIG. 5), the second hole 14h, and the third hole, and can be electrically connected to the display panel 11 (see FIG. 6) and the T-CON board TC. For example, the cable may be a Flat Flexible Cable FFC. The T-CON board TC can provide an image signal to the display panel 11.

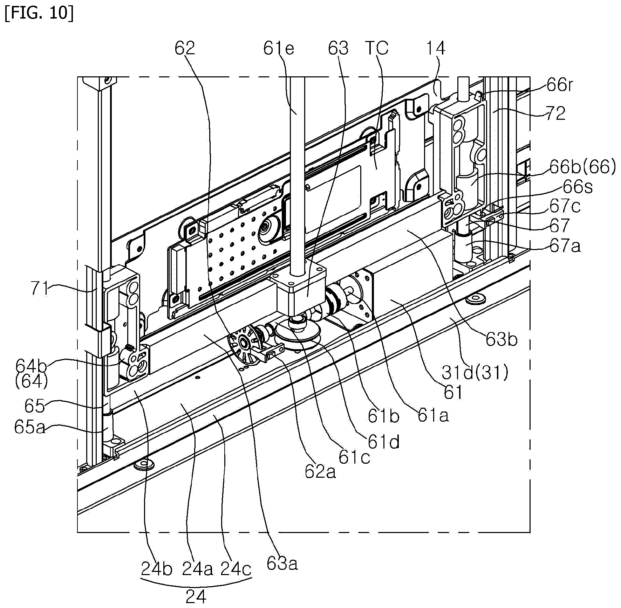

Referring to FIGS. 9 and 10, a drive module 60 may be installed on the fourth outer frame 24. The drive module 60 may be referred to as a lift assembly 60. The drive module 60 may include a motor 61, a coupling member 61b, a worm 61c, a worm wheel 61d, a lead screw 61e, a slider 63, an extension portion 63a, 63b, and a block 64, 66.

The motor 61 may provide rotational force. The motor 61 may be an electric motor. The motor 61 may be a motor whose rotation direction, rotation angle, and rotation speed can be adjusted. The motor 61 may be installed on the base 24a of the fourth outer frame 24.

The worm 61c may be coupled to a rotating shaft 61a of the motor 61 through the coupling member 61b and may rotate together with the rotating shaft 61a. The worm wheel 61d may be engaged with a thread formed on the outer circumferential surface of the worm 61c. The rotating shaft of the worm 61c may be parallel to the left-right direction, and the rotating shaft of the worm wheel 61d may be parallel to the vertical direction.

The lead screw 61e may extend in the vertical direction. The lead screw 61e may be located on a vertical line passing through the center of the display device. The lower end of the lead screw 61e may be fixed to the worm wheel 61d. The upper end of the lead screw 61e may be rotatably coupled to a top holder 61f fixed to the lower surface of the third outer frame 23. A male thread may be formed on the outer circumferential surface of the lead screw 61e.

The slider 63 may have an overall block shape. The lead screw 61e may penetrate the slider 63. A female thread may be formed inside the slider 63 and may engage with the male thread of the lead screw 61e.

A first extension portion 63a may extend from one side of the slider 63 to the left, and the distal end of the first extension portion 63a may be fixed to a first block 64. A second extension portion 63b may extend from the other side of the slider 63 to the right, and the distal end of the second extension portion 63b may be fixed to a second block 66.

A first shaft 65 may be parallel to the lead screw 61e and may be spaced to the left from the lead screw 61e. The lower end of the first shaft 65 may be coupled to or fixed to a first lower holder 65a fixed on the base 24a, and the upper end of the first shaft 65 may be coupled to or fixed to a first upper holder 65b fixed on the lower surface of the third outer frame 23. The first shaft 65 may penetrate the first block 64. For example, the first shaft 65 may be a metal rod.

A second shaft 67 may be parallel to the lead screw 61e and may be spaced to the right from the lead screw 61e. The lower end of the second shaft 67 may be coupled to or fixed to a second lower holder 67a fixed on the base 24a, and the upper end of the second shaft 67 may be coupled to or fixed to a second upper holder 67b fixed to the lower surface of the third outer frame 23. The second shaft 67 may penetrate the second block 66. For example, the second shaft 67 may be a metal rod.

Accordingly, when the motor 61 is driven, the slider 63 can stably perform a linear reciprocating motion along the lead screw 61e. When the rotating shaft 61a of the motor 61 rotates in a first rotation direction, the slider 63, the extension portion 63a, 63b, and the block 64, 66 can ascend. When the rotating shaft 61a of the motor 61 rotates in a second rotation direction opposite to the first rotation direction, the slider 63, the extension portion 63a, 63b, and the block 64, 66 can descend. Meanwhile, for example, the first shaft 65 and the first block 64 may be symmetrical with the second shaft 67 and the second block 66 with respect to the lead screw 61e.

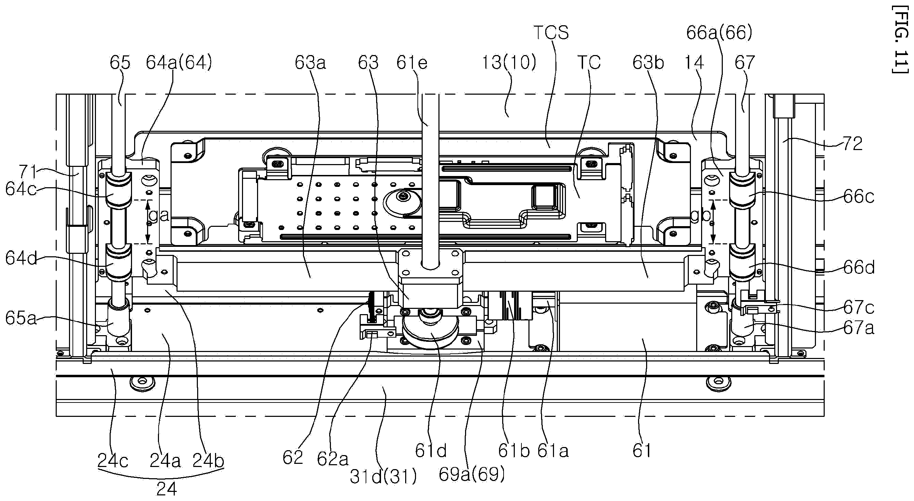

Referring to FIGS. 10 and 11, a portion of the first shaft 65 may be located between a first front block 64a and a first rear block 64b of the first block 64. The first rear block 64b may be coupled to the first front block 64a. A portion of the second shaft 67 may be located between a second front block 66a and a second rear block 66b of the second block 66. The second rear block 66b may be coupled to the second front block 66a.

A first bushing 64c, 64d may be inserted and fixed to between the first front block 64a and the first rear block 64b. The first bushing 64c, 64d may be formed between the first front block 64a and the first rear block 64b, and may be located in a groove (no reference numeral) surrounding the outer surface of the first bushing 64c, 64d. For example, the first bushing 64c, 64d may include a pair of first bushings 64c and 64d that are spaced apart from each other by a certain gap ga in the longitudinal direction of the first shaft 65. A second bushing 66c, 66d may be inserted and fixed to between the second front block 66a and the second rear block 66b. For example, the second bushing 66c, 66d may include a pair of second bushings 66c and 66d spaced apart from each other by a certain gap gb in the longitudinal direction of the second shaft 67.

Accordingly, the block 64, 66 can perform linear reciprocating motion more stably along the shaft 65, 67.

The first front block 64a may be coupled to or fixed to the rear surface of the plate 14. The second front block 66a of the second block 66 may be coupled to or fixed to the rear surface of the plate 14.

Accordingly, when the motor 61 is driven, the plate 14, the display unit 10, and the T-CON board TC may ascend or descend.

A first pin indicator 66s may be formed on the lower surface of the second block 66. A first sensor 67c may be adjacent to the lower end of the second bar 72 and may be fixed to the second bar 72. The first sensor 67c may be a photo sensor. The first sensor 67c can detect the approach of the first pin indicator 66s.

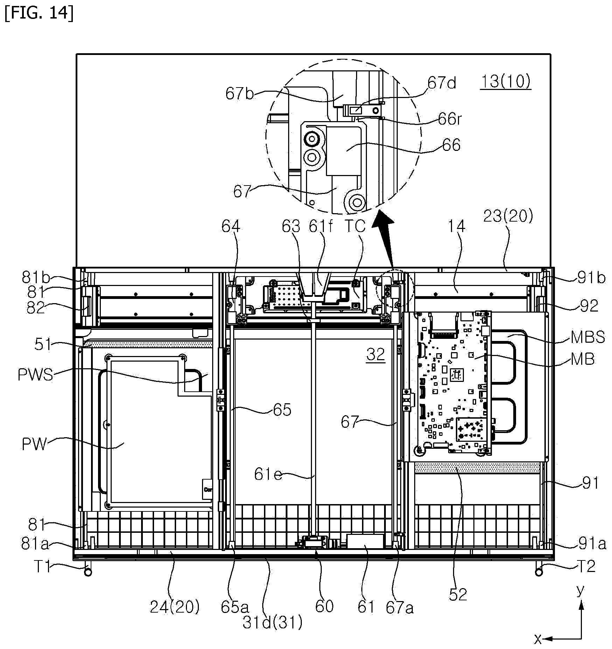

A second pin indicator 66r may be formed on the upper surface of the second block 66. A second sensor 67d (see FIGS. 8 and 14) may be adjacent to the upper end of the second bar 72 and may be fixed to the second bar 72. The second sensor 67d may be a photo sensor. The second sensor 67d can detect the approach of the second pin indicator 66r.

Accordingly, a controller of the display device may determine whether the display panel 11 is located at bottom dead center or top dead center, based on information obtained from the first sensor 67c or the second sensor 67d.

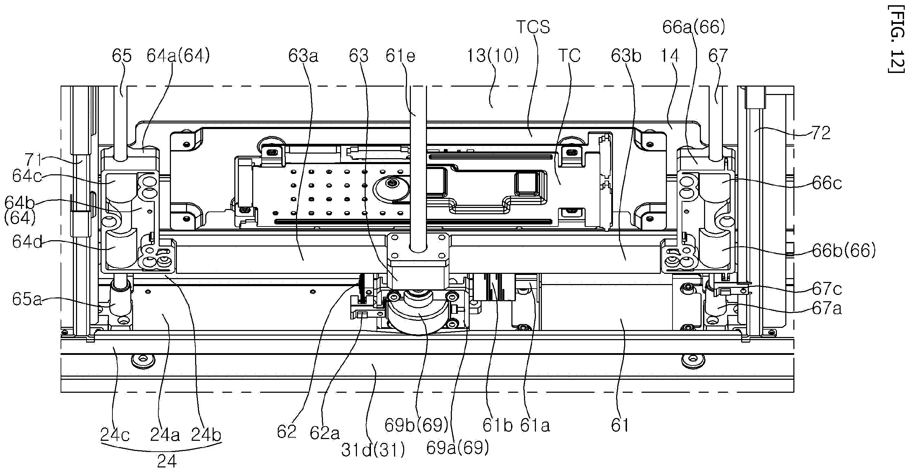

Referring to FIGS. 11 and 12, the above-described worm 61c and the worm wheel 61d may be located between the front housing 69a and the rear housing 69b. The rear housing 69b may be coupled to the front housing 69a.

A disk indicator 62 may be fixed to the rotating shaft of the worm 61c. A plurality of holes (no reference numeral) may be formed to penetrate the disc indicator 62 and may be spaced apart from each other in the circumferential direction of the disc indicator 62. The sensor 62a may be adjacent to the disk indicator 62 and may be fixed to the rear housing 69b. The sensor 62a may be a photo sensor. The sensor 62a can detect the rotation speed and/or rotation amount (rotation angle) of the disc indicator 62 and the motor 61.

Accordingly, the controller of the display device can control the driving of the motor 61 based on the information obtained by the sensor 62a.

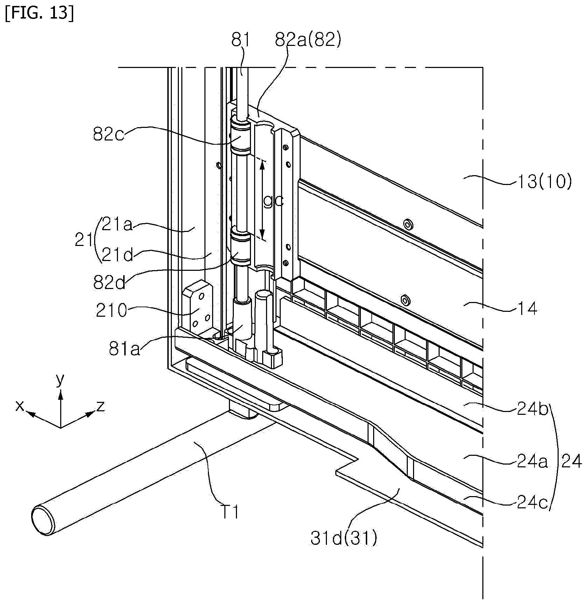

Referring to FIGS. 9 and 13, a first guide shaft 81 may be adjacent to the left distal end of the plate 14 and may be located in a rear of the plate 14. The first guide shaft 81 may be parallel to the lead screw 61e and may be opposite to the lead screw 61e with respect to the first shaft 65. The lower end of the first guide shaft 81 may be coupled to or fixed to a first bottom holder 81a fixed on the base 24a, and the upper end of the first guide shaft 81 may be coupled to or fixed to a first top holder 81b fixed to the lower surface of the third outer frame 23. For example, the first guide shaft 81 may be a metal rod.

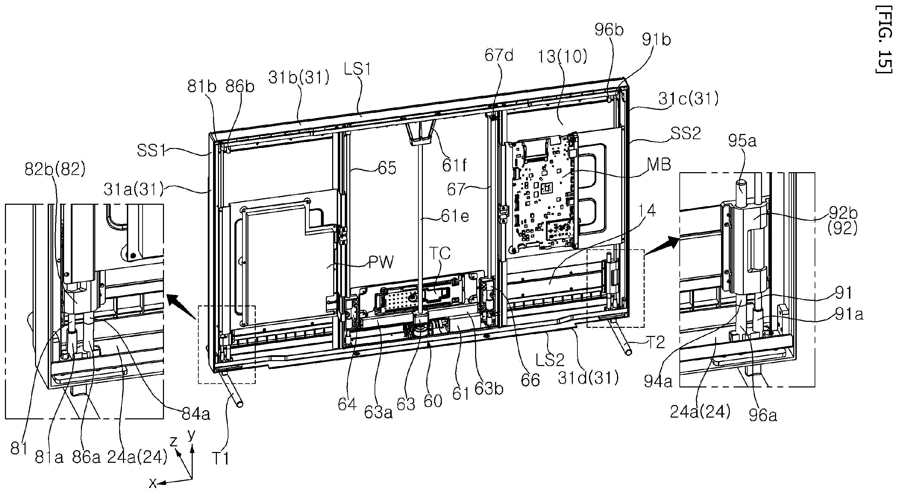

A first guide block 82 may be adjacent to the left distal end of the plate 14. A first front guide block 82a of the first guide block 82 may be coupled to the rear surface of the plate 14, and a first rear guide block 82b (see FIG. 15) of the first guide block 82 may be coupled to the first front guide block 82a. A first guide shaft 81 may be located between the first front guide block 82a and the first rear guide block 82b. That is, the first guide shaft 81 may penetrate the first guide block 82.

A second guide shaft 91 may be adjacent to the right distal end of the plate 14 and may be located in a rear of the plate 14. The second guide shaft 91 may be parallel to the lead screw 61e and may be opposite to the lead screw 61e with respect to the second shaft 67. The lower end of the second guide shaft 91 may be coupled to or fixed to a second bottom holder 91a fixed on the base 24a, and the upper end of the second guide shaft 91 may be coupled to or fixed to a second top holder 91b fixed to the lower surface of the third outer frame 23. For example, the second guide shaft 91 may be a metal rod.

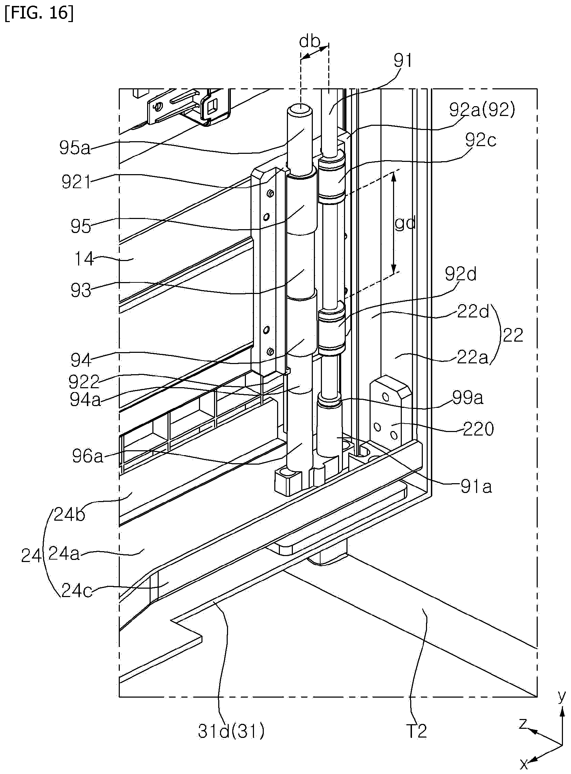

A second guide block 92 may be adjacent to the right distal end of the plate 14. A second front guide block 92a (see FIG. 16) of the second guide block 92 may be coupled to the rear surface of the plate 14, and a second rear guide block 92b (see FIG. 16) of the second guide block 92 may be coupled to the second front guide block 92a. A second guide shaft 91 may be located between the second front guide block 92a and the second rear guide block 92b. That is, the second guide shaft 91 may penetrate the second guide block 92.

Accordingly, when the motor 61 is driven, the guide block 82, 92 may ascend or descend along the guide shaft 81, 91. The guide block 82, 92 and the guide shaft 81, 91 can reduce the left-right distortion (e.g., the left-right tilt or left-right movement) of the ascending or descending plate 14. Meanwhile, for example, the first guide shaft 81 and the first guide block 82 may be symmetrical with the second guide shaft 91 and the second guide block 92 with respect to the lead screw 61e.

A first guide bushing 82c, 82d may be inserted and fixed to between the first front guide block 82a and the first rear guide block 82b (see FIG. 15). The first guide bushing 82c, 82d may be formed between the first front guide block 82a and the first rear guide block 82b, and located in a groove (no reference numeral) surrounding the outer surface of the first guide bushing 82c, 82d. For example, the first guide bushing 82c, 82d may include a pair of first guide bushings 82c and 82d that are spaced apart from each other by a certain gap gc in the longitudinal direction of the first guide shaft 81.

A second guide bushing 92c, 92d (see FIG. 16) can be inserted and fixed to between the second front guide block 92a (see FIG. 16) and the second rear guide block 92b (see FIG. 15). The second guide bushing 92c, 92d may be formed between the second front guide block 92a and the second rear guide block 92b, and located in a groove (no reference numeral) surrounding the outer surface of the second guide bushing 92c, 92d. For example, the second guide bushing 92c, 92d may include a pair of second guide bushings 92c and 92d that are spaced apart from each other by a certain gap gd in the longitudinal direction of the second guide shaft 91.

Accordingly, the guide block 82, 92 can perform linear reciprocating motion more stably along the guide shaft 81, 91. The guide block 82, 92 and the guide shaft 81, 91 can minimize the left-right distortion (e.g., the left-right tilt or left-right movement) of the ascending or descending plate 14.

Referring to FIG. 14, when the rotating shaft of the motor 61 rotates in a first rotation direction, the slider 63 may ascend along the lead screw 61e. The block 64, 66 coupled with the slider 63 can ascend along the shaft 65, 67. The plate 14 coupled with the block 64, 66, and the display unit 10 and the T-CON board TC coupled with the plate 14 can also ascend. In addition, the guide block 82, 92 coupled with the plate 14 may ascend along the guide shaft 81, 91.

When the rotating shaft of the motor 61 rotates in a second rotation direction opposite to the first rotation direction, the slider 63, the block 64, 66, the plate 14, the display unit 10, the T-CON board TC, and the guide block 82, 92 can descend.

Referring to FIG. 15, a first bottom protrusion 86a may be adjacent to the first bottom holder 81a and may be fixed on the base 24a. The first bottom protrusion 86a may be located on the right side of the first bottom holder 81a. The first bottom protrusion 86a may face the first guide block 82. The first bottom protrusion 86a may have a vertically elongated cylinder shape. The length of the first bottom protrusion 86a may be longer than the length of the first bottom holder 81a. For example, the first bottom protrusion 86a may be formed as one body with the first bottom holder 81a.

A first top protrusion 86b may be adjacent to the first top holder 81b and may be fixed to the lower surface of the third outer frame 23. The first top protrusion 86b may be located on the right side of the first top holder 81b. In the vertical direction, the first top protrusion 86b may be aligned with the first bottom protrusion 86a. The first top protrusion 86b may have a vertically elongated cylinder shape. The length of the first top protrusion 86b may be longer than the length of the first top holder 81b. For example, the first top protrusion 86b may be formed as one body with the first top holder 81b.

A second bottom protrusion 96a may be adjacent to the second bottom holder 91a and may be fixed on the base 24a. The second bottom protrusion 96a may be located on the left side of the second bottom holder 91a. The second bottom protrusion 96a may face the second guide block 92. The second bottom protrusion 96a may have a vertically elongated cylinder shape. The length of the second bottom protrusion 96a may be greater than the length of the second bottom holder 91a. For example, the second bottom protrusion 96a may be formed as one body with the second bottom holder 91a.

A second top protrusion 96b may be adjacent to the second top holder 91b and may be fixed to the lower surface of the third outer frame 23. The second top protrusion 96b may be located on the left side of the second top holder 91b. In the vertical direction, the second top protrusion 96b may be aligned with the second bottom protrusion 96a. The second top protrusion 96b may have a vertically elongated cylinder shape. The length of the second top protrusion 96b may be greater than the length of the second top holder 91b. For example, the second top protrusion 96b may be formed as one body with the second top holder 91b.

For example, the second bottom protrusion 96a and the second top protrusion 96b may be symmetrical with the first bottom protrusion 86a and the first top protrusion 86b with respect to the lead screw 61e.

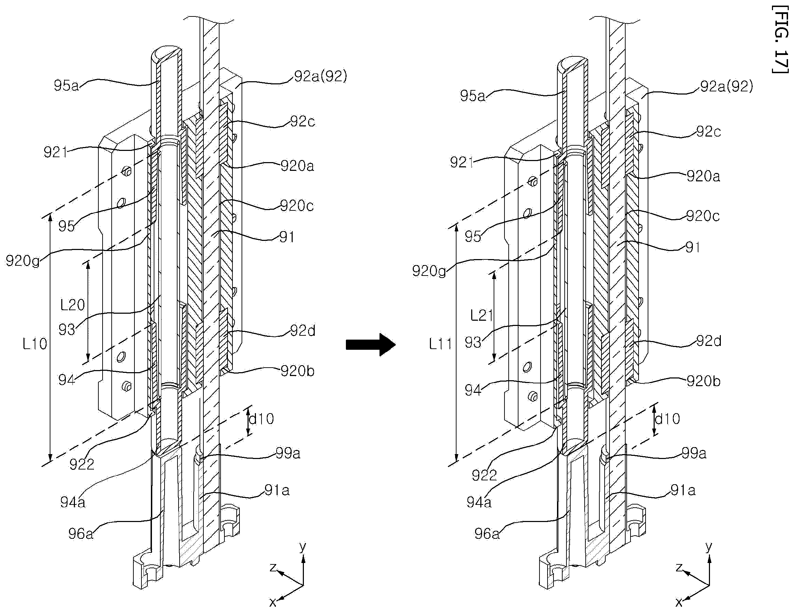

Referring to FIGS. 16 and 17, a second buffer member 93, 94, 94a, 95, 95a may be located between the second front guide block 92a and the second rear guide block 92b, (see FIG. 15). The second buffer member 93, 94, 94a, 95, 95a may be inserted into a second groove 920g formed between the front guide block 92a and the second rear guide block 92b. The second buffer member 93, 94, 94a, 95, 95a may be adjacent to the second guide bushing 92c, 92d and may be located in parallel with the second guide bushing 92c, 92d. The second buffer member 93, 94, 94a, 95, 95a may include a second elastic member 93, a second lower stopper 94, 94a, and a second upper stopper 95, 95a.

The second elastic member 93 may extend in the vertical direction. The second elastic member 93 may be stretched or compressed in the vertical direction. For example, the second elastic member 93 may be a spring. The second elastic member 93 may be located between the second lower stopper 94, 94a and the second upper stopper 95, 95a, and may be coupled or fixed to the second lower stopper 94, 94a and the second upper stopper 95, 95a.

The second lower stopper 94, 94a may include a second lower insertion portion 94 and a second lower pin 94a. The second lower insertion portion 94 may be inserted into the second groove 920g and may have a cylindrical shape. The outer diameter of the second lower insertion portion 94 may be substantially the same as the inner diameter of the second groove 920g. The second lower pin 94a may extend from the lower end of the second lower insertion portion 94 toward the second bottom protrusion 96a and may have a cylindrical shape. The outer diameter of the second lower pin 94a may be smaller than the outer diameter of the second lower insertion portion 94. For example, the second lower insertion portion 94 and the second lower pin 94a may be formed as one body. For example, the upper side of the second lower stopper 94, 94a may be open while the lower side may be blocked.

A second lower rib 922 may protrude from the lower end of the second groove 920g toward the second lower pin 94a and may extend along the outer circumference of the second lower pin 94a. In the vertical direction, the second lower rib 922 may overlap with a step between the second lower insertion portion 94 and the second lower pin 94a. That is, the second lower rib 922 may restrict the downward movement of the second lower stopper 94, 94a.

The second upper stopper 95, 95a may include a second upper insertion portion 95 and a second upper pin 95a. The second upper insertion portion 95 may be inserted into the second groove 920g and may have a cylindrical shape. The outer diameter of the second upper insertion portion 95 may be substantially the same as the inner diameter of the second groove 920g. The second upper pin 95a may extend from the upper end of the second upper insertion portion 95 toward the second top protrusion 96b and may have a cylindrical shape. The outer diameter of the second upper pin 95a may be smaller than the outer diameter of the second upper insertion portion 95. For example, the second upper insertion portion 95 and the second upper pin 95a may be formed as one body. For example, the lower side of the second upper stopper 95, 95a may be open while the upper side may be blocked.

A second upper rib 921 may protrude from the upper end of the second groove 920g toward the second upper pin 95a and may extend along the outer circumference of the second upper pin 95a. In the vertical direction, the second upper rib 921 may overlap with a step between the second upper insertion portion 95 and the second upper pin 95a. That is, the second upper rib 921 may restrict the downward movement of the second upper stopper 95, 95a.

The lower portion of the above-described second elastic member 93 may be inserted into the inner side of the second lower insertion portion 94, and the lower end of the second elastic member 93 may be fixed to the inner side of the second lower insertion portion 94 or the second lower pin 94a. The upper portion of the above-described second elastic member 93 may be inserted into the inner side of the second upper insertion portion 95, and the upper end of the second elastic member 93 may be fixed to the inner side of the second upper insertion portion 95 or the second upper pin 95a.

Referring to the left drawing of FIG. 17, the second lower pin 94a may be spaced upward from the second bottom protrusion 96a. At this time, due to the elastic force of the second elastic member 93, the second lower stopper 94, 94a may be caught on the second lower rib 922, and the second upper stopper 95, 95a may be caught on the second upper rib 921. The gap between the second upper stopper 95, 95a and the second lower stopper 94, 94a may be L20, and the gap between the step of the second upper stopper 95, 95a and the step of the second lower stopper 94, 94a may be L10.

Referring to the right drawing of FIG. 17, in response to the descending of the second guide block 92, the second lower pin 94a may be in contact with the second bottom protrusion 96a. At this time, the second elastic member 93 can be compressed, and the second lower stopper 94, 94a can ascend upward within the second groove 920g. The gap L21 between the second upper stopper 95, 95a and the second lower stopper 94, 94a may be smaller than L20, and the gap L11 between the step of the second upper stopper 95, 95a and the step of the second lower stopper 94, 94a may be smaller than L10.

Accordingly, the second lower stopper 94, 94a can alleviate the impact at a time when the second guide block 92 and the display unit 10 (see FIG. 15), etc., descend.

In addition, the outer diameter of the second bottom protrusion 96a may be equal to or smaller than the inner diameter of the second lower rib 922. The second bottom protrusion 96a may be inserted into the second groove 920g in response to the descending of the second guide block 92.

For example, the ascend of the second lower stopper 94, 94a within the second groove 920g can be restricted by contact between the upper end of the second lower insertion portion 94 and the lower end of the second upper insertion portion 95.

For example, the ascend of the second lower stopper 94, 94a within the second groove 920g may be restricted by contact between the lower side of the second guide block 92 and the upper end of the second bottom holder 91a. A second lower cushion 99a may be located between the lower side of the second guide block 92 and the upper end of the second bottom holder 91a, and may be coupled to the upper end of the second bottom holder 91a. Alternatively, the second lower cushion 99a may be coupled to the lower side of the second guide block 92. The second lower cushion 99a may surround the outer circumference of the second guide shaft 91. For example, the second lower cushion 99a may include an elastic material such as rubber or silicon.

Meanwhile, the above-described second buffer member 93, 94, 94a, 95, 95a, the relationship between the second buffer member 93, 94, 94a, 95, 95a, and the second bottom protrusion 96a, the relationship between the second buffer member 93, 94, 94a, 95, 95a and the second bottom holder 91a, and content on the second lower cushion 99a can be identically applied to the first buffer member located in the first guide block 82 (see FIG. 15), the relationship between the first buffer member and the first bottom protrusion 86a (see FIG. 15), the relationship between the first buffer member and the first bottom holder 81a (see FIG. 15), and the first lower cushion.

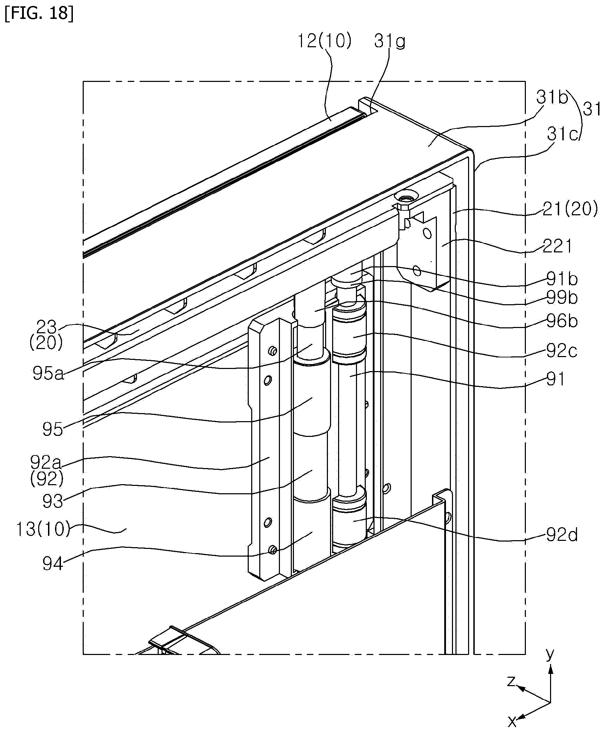

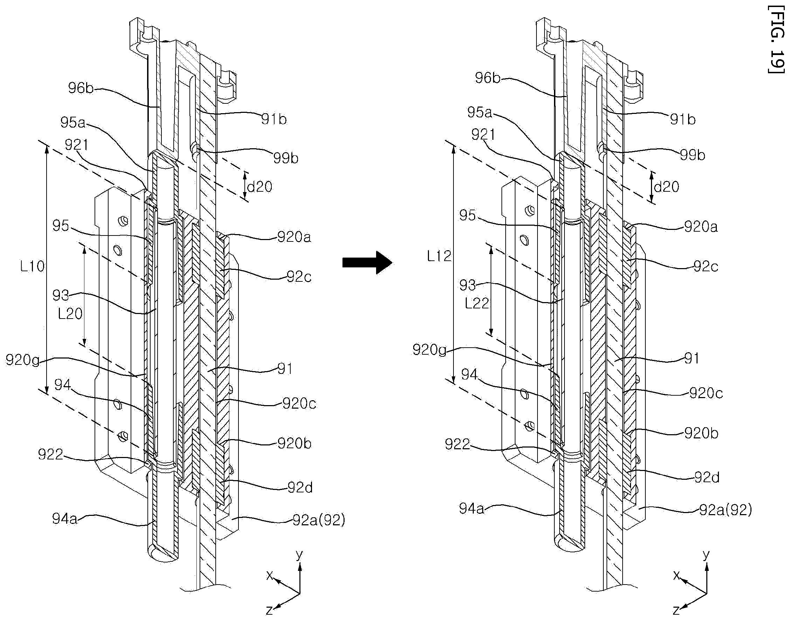

Referring to FIGS. 18 and 19, the second buffer member 93, 94, 94a, 95, 95a may be in contact with or spaced apart from the second top protrusion 96b.

Referring to the left drawing of FIG. 19, the second upper pin 95a may be spaced downward from the second top protrusion 96b. At this time, due to the elastic force of the second elastic member 93, the second upper stopper 95, 95a may be caught on the second upper rib 921, and the second lower stopper 94, 94a may be caught on the second lower rib 922. The gap between the second upper stopper 95, 95a and the second lower stopper 94, 94a may be L20, and the gap between the step of the second upper stopper 95, 95a and the step of the second lower stopper 94, 94a may be L10.

Referring to the right drawing of FIG. 19, in response to the ascend of the second guide block 92, the second upper pin 95a may be in contact with the second top protrusion 96b. At this time, the second elastic member 93 may be compressed, and the second upper stopper 95, 95a may descend downward within the second groove 920g. The gap L22 between the second upper stopper 95, 95a and the second lower stopper 94, 94a may be smaller than L20, and the gap L22 between the step of the second upper stopper 95, 95a and the step of the second lower stopper 94, 94a may be smaller than L10.

Accordingly, the second upper stopper 95, 95a can alleviate the impact at a time when the second guide block 92 and the display unit 10 (see FIG. 15) ascend.

In addition, the outer diameter of the second top protrusion 96b may be equal to or smaller than the inner diameter of the second upper rib 921. The second top protrusion 96b may be inserted into the second groove 920g in response to the ascending of the second guide block 92.

For example, the descending of the second upper stopper 95, 95a within the second groove 920g may be restricted by the contact between the lower end of the second upper insertion portion 95 and the upper end of the second lower insertion portion 94.

For example, the descending of the second upper stopper 95, 95a within the second groove 920g may be restricted by contact between the upper side of the second guide block 92 and the lower end of the second top holder 91b. The second upper cushion 99b may be located between the upper side of the second guide block 92 and the lower end of the second top holder 91b, and may be coupled to the lower end of the second top holder 91b. Alternatively, the second upper cushion 99b may be coupled to the upper side of the second guide block 92. The second upper cushion 99b may surround the outer circumference of the second guide shaft 91. For example, the second upper cushion 99b may include an elastic material such as rubber or silicone.

Meanwhile, the above-described second buffer member 93, 94, 94a, 95, 95a, the relationship between the second buffer member 93, 94, 94a, 95, 95a and the second top protrusion 96b, the relationship between the second buffer member 93, 94, 94a, 95, 95a and the second top holder 91b, and the content on the second upper cushion 99b may be identically applied to the first buffer member located within the first guide block 82 (see FIG. 15), the relationship between the first buffer member and the first top protrusion 86b (see FIG. 15), the relationship between the first buffer member and the first top holder 81b (see FIG. 15), and the first upper cushion.

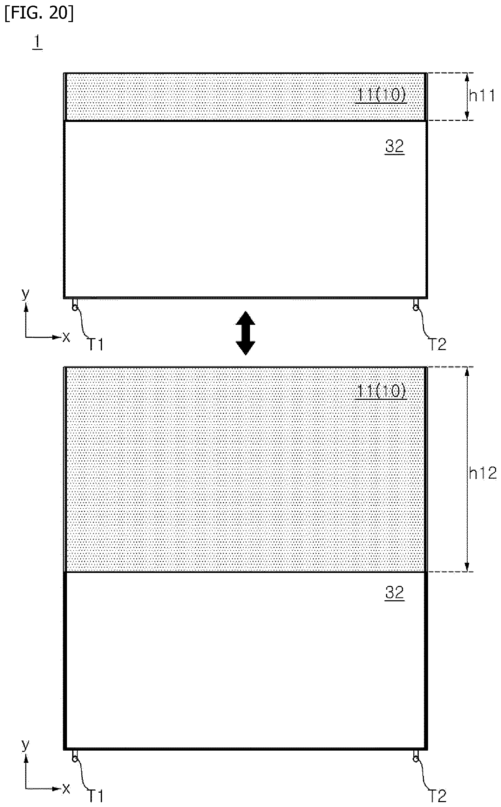

Referring to FIGS. 1 and 20, the display panel 11 can move in the up-down direction at the rear of the front case 32. The slot or groove 31g may be formed by cutting out the front end of the second part 31b of the side case 31, and to which the middle cabinet 12 may pass through.

The display panel 11 may be gradually covered by the front case 32 as it moves downward. The display panel 11 may be gradually exposed to the front as it moves upward.

For example, the minimum height of the display panel 11 exposed to the front may be 0 to h11. For example, the maximum height of the display panel 11 exposed to the front may be h12.

Referring to FIGS. 1 and 20, a display device according to an aspect of the present disclosure may include a base; a drive module coupled to the base, the drive module including a slider which performs a linear reciprocating motion; a plate coupled to the slider; a display panel coupled to the plate in front of the plate; a first guide shaft which extends in a direction of movement of the slider, and to which one end of the plate is movably coupled; and a second guide shaft which is opposite to the first guide shaft with respect to the slider, which is parallel to the first guide shaft, and to which the other end of the plate is movably coupled.

The display device may further include a front case located in front of the display panel, the display panel ascends or descends, and has a front surface which is opened or closed by the front case.

The display device may further include a first guide block which is adjacent to one end of the plate, which is coupled to the plate, and through which the first guide shaft passes; and a second guide block which is adjacent to the other end of the plate, which is coupled to the plate, and through which the second guide shaft passes.

The first guide block may be symmetrical to the second guide block with respect to a virtual line which passes through a center of the slider and extends in the direction of movement of the slider.

The first guide block may further include a plurality of first guide bushings which are located in the first guide block, which surround the first guide shaft, and which are spaced apart from each other in a longitudinal direction of the first guide shaft.

The first guide block may further include a first elastic member which is located in the first guide block and which is compressible in a longitudinal direction of the first guide shaft; a first lower stopper which is movable in the longitudinal direction of the first guide shaft in the first guide block, and to which one end of the first elastic member is fixed; and a first upper stopper which is movable in the longitudinal direction of the first guide shaft in the first guide block, and to which the other end of the first elastic member is fixed.

The display device further includes a first bottom protrusion which is coupled to the base and which faces the first lower stopper, the first lower stopper may further include a first lower insertion portion which is located in the first guide block and has a first outer diameter; and a first lower pin which extends from the first lower insertion portion toward the first bottom protrusion and has a second outer diameter smaller than the first outer diameter, the first lower pin being in contact with or spaced apart from the first bottom protrusion, the first guide block may further include a first lower rib which is formed at an inner side of the first guide block, and which overlaps with a step between the first lower insertion portion and the first lower pin in a moving direction of the first lower stopper.

The display device may further include an outer frame opposite to the base with respect to the first guide shaft; and a first top protrusion which is coupled to the outer frame and which faces the first upper stopper, the first upper stopper may further include a first upper insertion portion which is located in the first guide block and which has a third outer diameter; and a first upper pin which extends from the first upper insertion portion toward the first top protrusion and which has a fourth outer diameter smaller than the third outer diameter, the first upper pin being in contact with or spaced apart from the first top protrusion, the first guide block may further include a first upper rib which is formed at an inner side of the first guide block and which overlaps with a step between the first upper insertion portion and the first upper pin in a moving direction of the first upper stopper.

An outer diameter of the first bottom protrusion may be equal to or smaller than an inner diameter of the first lower rib, an outer diameter of the first top protrusion may be equal to or smaller than an inner diameter of the first upper rib, and the first lower insertion portion and the first upper insertion portion may be spaced apart or in contact with each other.

The display device may further include a first bottom holder which is coupled to the base and to which one end of the first guide shaft is coupled; a first lower cushion which is located between the first bottom holder and the first guide block, which is coupled to the first bottom holder or the first guide block, and which surrounds an outer circumference of the first guide shaft; a first top holder which is coupled to the outer frame and to which the other end of the first guide shaft is coupled; and a first upper cushion which is located between the first top holder and the first guide block, which is coupled to the first top holder or the first guide block, and which surrounds the outer circumference of the first guide shaft.

The display device further includes a frame which includes the base, and to which the first guide shaft and the second guide shaft are coupled, the drive module may further include a lead screw which is located between the first guide shaft and the second guide shaft, which extends in the direction of movement of the slider, and which is rotatably coupled to the frame, and the slider may be screwed with the lead screw and movable along the lead screw.

The drive module may further include a motor which provides power to the slider; a worm fixed to a rotating shaft of the motor; and a worm wheel which is engaged with the worm, and to which the lead screw is fixed.

The drive module may further include a first shaft which is located between the first guide shaft and the lead screw, which is parallel to the lead screw, and which is coupled to the frame; a second shaft which is opposite to the first guide shaft with respect to the lead screw, which is parallel to the lead screw, and which is coupled to the frame; a first extension portion which extends from one side of the slider toward the first shaft, and which is movably coupled to the first shaft; and a second extension portion which extends from the other side of the slider toward the second shaft, and which is movably coupled to the second shaft.

The drive module further includes a first block which has one side coupled to the first extension portion and the other side coupled to the plate, and through which the first shaft passes, the first block including a plurality of bushings which are located within the first block, which surround the first shaft, and which are spaced apart from each other in a longitudinal direction of the first shaft; and a second block which has one side coupled to the second extension portion and the other side coupled to the plate, and through which the second shaft passes, the second block including a plurality of bushings which are located in the second block, which surround the second shaft, and which are spaced apart from each other in a longitudinal direction of the second shaft.

The display device may further include a module cover which is located between the display panel and the plate, and which is coupled to the display panel, the module cover having a first hole formed through the module cover; and a T-CON board which is opposite to the module cover with respect to the plate, and which is coupled to the plate, the plate is adjacent to a lower side of the module cover, is coupled to the module cover, and has a second hole which is aligned with the first hole.

Certain embodiments or other embodiments of the disclosure described above are not mutually exclusive or distinct from each other. Any or all elements of the embodiments of the disclosure described above may be combined or combined with each other in configuration or function.

For example, a configuration "A" described in one embodiment of the disclosure and the drawings and a configuration "B" described in another embodiment of the disclosure and the drawings may be combined with each other. Namely, although the combination between the configurations is not directly described, the combination is possible except in the case where it is described that the combination is impossible.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A display device comprising:
a base;
a drive module coupled to the base, the drive module including a slider which performs a linear reciprocating motion;
a plate coupled to the slider;
a display panel coupled to the plate in front of the plate;
a first guide shaft which extends in a direction of movement of the slider, and to which one end of the plate is movably coupled; and
a second guide shaft which is opposite to the first guide shaft with respect to the slider, which is parallel to the first guide shaft, and to which the other end of the plate is movably coupled.

2. The display device of claim 1, further comprising a front case located in front of the display panel,
wherein the display panel ascends or descends, and has a front surface which is opened or closed by the front case.

3. The display device of claim 1, further comprising:
a first guide block which is adjacent to one end of the plate, which is coupled to the plate, and through which the first guide shaft passes; and
a second guide block which is adjacent to the other end of the plate, which is coupled to the plate, and through which the second guide shaft passes.

4. The display device of claim 3, wherein the first guide block is symmetrical to the second guide block with respect to a virtual line which passes through a center of the slider and extends in the direction of movement of the slider.

5. The display device of claim 3, wherein the first guide block further comprises a plurality of first guide bushings which are located in the first guide block, which surround the first guide shaft, and which are spaced apart from each other in a longitudinal direction of the first guide shaft.

6. The display device of claim 3, wherein the first guide block further comprises:
a first elastic member which is located in the first guide block and which is compressible in a longitudinal direction of the first guide shaft;
a first lower stopper which is movable in the longitudinal direction of the first guide shaft in the first guide block, and to which one end of the first elastic member is fixed; and
a first upper stopper which is movable in the longitudinal direction of the first guide shaft in the first guide block, and to which the other end of the first elastic member is fixed.

7. The display device of claim 6, further comprising a first bottom protrusion which is coupled to the base and which faces the first lower stopper,
wherein the first lower stopper further comprises:
a first lower insertion portion which is located in the first guide block and has a first outer diameter; and
a first lower pin which extends from the first lower insertion portion toward the first bottom protrusion and has a second outer diameter smaller than the first outer diameter, the first lower pin being in contact with or spaced apart from the first bottom protrusion,
wherein the first guide block further comprises a first lower rib which is formed at an inner side of the first guide block, and which overlaps with a step between the first lower insertion portion and the first lower pin in a moving direction of the first lower stopper.

8. The display device of claim 7, further comprising:
an outer frame opposite to the base with respect to the first guide shaft; and
a first top protrusion which is coupled to the outer frame and which faces the first upper stopper,
wherein the first upper stopper further comprises:
a first upper insertion portion which is located in the first guide block and which has a third outer diameter; and
a first upper pin which extends from the first upper insertion portion toward the first top protrusion and which has a fourth outer diameter smaller than the third outer diameter, the first upper pin being in contact with or spaced apart from the first top protrusion,
wherein the first guide block further comprises a first upper rib which is formed at an inner side of the first guide block and which overlaps with a step between the first upper insertion portion and the first upper pin in a moving direction of the first upper stopper.

9. The display device of claim 8, wherein an outer diameter of the first bottom protrusion is equal to or smaller than an inner diameter of the first lower rib,
wherein an outer diameter of the first top protrusion is equal to or smaller than an inner diameter of the first upper rib,
wherein the first lower insertion portion and the first upper insertion portion are spaced apart or in contact with each other.

10. The display device of claim 8, further comprising a first bottom holder which is coupled to the base and to which one end of the first guide shaft is coupled;
a first lower cushion which is located between the first bottom holder and the first guide block, which is coupled to the first bottom holder or the first guide block, and which surrounds an outer circumference of the first guide shaft;
a first top holder which is coupled to the outer frame and to which the other end of the first guide shaft is coupled; and
a first upper cushion which is located between the first top holder and the first guide block, which is coupled to the first top holder or the first guide block, and which surrounds the outer circumference of the first guide shaft.

11. The display device of claim 1, further comprising a frame which includes the base, and to which the first guide shaft and the second guide shaft are coupled,
wherein the drive module further comprises a lead screw which is located between the first guide shaft and the second guide shaft, which extends in the direction of movement of the slider, and which is rotatably coupled to the frame,
wherein the slider is screwed with the lead screw and movable along the lead screw.

12. The display device of claim 11, wherein the drive module further comprises:
a motor which provides power to the slider;
a worm fixed to a rotating shaft of the motor; and
a worm wheel which is engaged with the worm, and to which the lead screw is fixed.

13. The display device of claim 11, wherein the drive module further comprises:
a first shaft which is located between the first guide shaft and the lead screw, which is parallel to the lead screw, and which is coupled to the frame;
a second shaft which is opposite to the first guide shaft with respect to the lead screw, which is parallel to the lead screw, and which is coupled to the frame;
a first extension portion which extends from one side of the slider toward the first shaft, and which is movably coupled to the first shaft; and
a second extension portion which extends from the other side of the slider toward the second shaft, and which is movably coupled to the second shaft.

14. The display device of claim 13, wherein the drive module further comprises:
a first block which has one side coupled to the first extension portion and the other side coupled to the plate, and through which the first shaft passes, the first block including a plurality of bushings which are located in the first block, which surround the first shaft, and which are spaced apart from each other in a longitudinal direction of the first shaft; and
a second block which has one side coupled to the second extension portion and the other side coupled to the plate, and through which the second shaft passes, the second block including a plurality of bushings which are located in the second block, which surround the second shaft, and which are spaced apart from each other in a longitudinal direction of the second shaft.

15. The display device of claim 1, further comprising:
a module cover which is located between the display panel and the plate, and which is coupled to the display panel, the module cover having a first hole formed through the module cover; and
a T-CON board which is opposite to the module cover with respect to the plate, and which is coupled to the plate,
wherein the plate is adjacent to a lower side of the module cover, is coupled to the module cover, and has a second hole which is aligned with the first hole.
